(19) **Europäisches Patentamt**

**European Patent Office**

**Office européen des brevets**

(11) **EP 0 584 447 B1**

(12) **EUROPÄISCHE PATENTSCHRIFT**

(45) Veröffentlichungstag und Bekanntmachung des Hinweises auf die Patenterteilung:
**11.06.1997  Patentblatt 1997/24**

(51) Int Cl.$^6$: **G01R 15/24**

(21) Anmeldenummer: **93103817.8**

(22) Anmeldetag: **10.03.1993**

(54) **Strommessanordnung für eine Kabelstrecke**

Current measuring appliance for a length of cable

Dispositif de mesure de courant pour câble

(84) Benannte Vertragsstaaten:
**AT BE FR GB IT NL**

(30) Priorität: **22.08.1992  DE 4227904**

(43) Veröffentlichungstag der Anmeldung:
**02.03.1994  Patentblatt 1994/09**

(73) Patentinhaber: **Felten & Guilleaume Energietechnik AG**
**D-51058 Köln (DE)**

(72) Erfinder:
• **Harjes, Bernd, Dr. Ing.**
**W-5060 Bergisch Gladbach 2 (DE)**

• **Senftleben, Hartwig, Dipl.-Ing.**
**W-4600 Dortmund 1 (DE)**
• **Peier, Dirk, Prof. Dr. Ing.**
**W-4600 Dortmund 50 (DE)**

(56) Entgegenhaltungen:
EP-A- 0 108 012      EP-A- 0 452 218
DE-A- 2 835 794      DE-A- 2 924 804
DE-A- 3 615 557

• **IEEC J LIGHTWAVE TECHN Bd. 7, Nr. 12 , Dezember 1989 Seiten 2084 - 2094 LAMING UND PAYNE 'electric current sensors employing spun highly birefringent optical fibers'**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft eine Strommeßanordnung für eine einseitig gespeiste Strecke einer Energieader eines Energiekabels mit mindestens zwei polarisationserhaltenden Lichtwellenleitern, die als Faraday-Spulen ausgebildet sind und mit an einem Ende der Strecke vorhandenen Einrichtungen zum Ein- und Auskoppeln von Licht und mit einer Einrichtung zur Auswertung optischer Signale.

Es wurde schon vorgeschlagen, zwei in gleich langen Kabelstrecken integrierte Lichtwellenleiter jeweils mit unterschiedlichem Schlag in Reihe hintereinander zu schalten und diese Anordnung als Einrichtung zur Detektion eines Fehlerstroms über die Änderung des Drehwinkels der Polarisationsebene (Faraday-Effekt) zu verwenden (EP 0 108 012). In einer Strommeßanordnung der eingangs genannten Art wurde vorgeschlagen, in derselben Kabelstrecke zwei langgestreckte Lichtwellenleiterspulen entgegengesetzer Schlagrichtung hintereinander zu schalten (DE 36 15 557). Mit solchen Anordnungen ist es jedoch nicht möglich, die Fehlerstromstärke oder sogar die örtliche Lage des Fehlers in einer einseitig gespeisten Kabelstrecke festzustellen. Solche Anordnungen haben nur die Eigenschaft eines Fehlermelders, solange der Fehler nicht am Anfang oder am Ende der Strecke auftritt.

Der Erfindung liegt die Aufgabe zugrunde, eine Strommeßanordnung der eingangs genannten Art anzugeben, welche es gestattet, genauere Daten über den Fehlerstrom und insbesondere auch über den Fehlerstromort einer einseitig gespeisten Energiestrecke zu ermitteln.

Die Aufgabe wird erfindungsgemäß mit den Merkmalen des Hauptanspruchs gelöst. Vorteilhafte Weiterbildungen finden sich in den Unteransprüchen.

Technische Vorteile der Strommeßanordnung: Sie ist ein Dreifachsystem. Mit ihr ist die Messung (und Überwachung) des Betriebsstroms möglich und sie ist sowohl als Differential-, als auch als Distanzschutz einsetzbar.

Mit der Erfindung wird eine Kombination einer konzentrierten und einer verteilten Lichtwellenleiterspule in einer Energieleitung realisiert, die beide einzeln von außen angesteuert werden, wo ihre Meßwerte ausgewertet werden. Als konzentrierter Stromsensor wird eine enggewickelte Lichtwellenleiter-Spule und als verteilter Stromsensor eine Lichtwellenleiter-Spule mit langem Schlag verstanden, mit denen jeweils die Stromstärke in einem elektrischen Leiter aufgrund des Faraday-Effekts meßbar ist. Die so beschriebenen Lichtwellenleiterspulen werden im folgenden als Faraday-Spulen bezeichnet. Das Magnetfeld der Energieader (oder des Kabelschirms) erzeugt aufgrund des Faraday-Effekts eine Drehung der Polarisationsebene des in den Lichtwellenleiter eingestrahlten Lichts (in der Regel im infraroten Wellenlängenbereich). In konzentrierten Stromsensoren wird die Messung des Faraday-Effekts auf eine im Vergleich zur Länge der Energieleitung (km) vernachlässigbar kurzen Strecke (cm) begrenzt. Verteilte Stromsensoren erfassen die Faraday- Drehung demgegenüber auf einer ausgedehnten Strecke, bis hin zur gesamten Leitungslänge.

Es ist bekannt, daß sich torsionsbedingte reziproke Störeffekte, z.B. der Temperatureinfluß, bei der Umkehrung des optischen Weges auslöschen, während der nichtreziproke Faraday-Effekt in seiner Wirkung verdoppelt wird. Die Verdopplung des Lichtweges wird erreicht, indem das Licht am Ende der Faraday-Spule mit einem Spiegel reflektiert wird (DE 2924804).

Die Lichtwellenleiter der Stromsensoren werden an einem Ende aus der den Leiter aufnehmenden Energieleitung (z.B. Kabel) herausgeführt und mit Einrichtungen versehen, um die optischen Signale ein- und auszukoppeln. Die ausgekoppelten Signale werden einer Auswerteeinrichtung (z. B. in einer Leitwarte) zugeführt. Es ist bekannt, Lichtwellenleiter nicht nur in Kabeln sondern auch in Muffen oder Endverschlüssen zu integrieren, so daß schon bei der Herstellung der Kabel, Muffen und Endverschlüsse die Voraussetzung für eine integrierte Strommeßanordnung geschaffen werden kann.

Störeinflüsse können in Lichtwellenleitern lineare Doppelbrechung erzeugen, die eine Fortleitung des Faraday-Signals unmöglich macht. Es werden daher für die Ausbildung des faseroptischen Stromsensors solche Lichtwellenleiter eingesetzt, bei denen der Polarisationszustand der geführten Lichtwelle nicht durch Störungen beeinflußt ist. Beispiele solcher Lichtwellenleiter sind Speziallichtwellenleiter ("spun high birefringence" im Aufsatz von R.I. Laming und D.N.Payne in IEEC J Lightwave Techn 7:1989: 2084) oder durch Torsion gewöhnlicher Monomode-Fasern präparierte Lichtwellenleiter (DE 2835794).

Im folgenden sollen die Lichtwellenleiter, die den Polarisationszustand der optischen Welle nicht beeinflussen, als polarisationserhaltende Lichtwellenleiter bezeichnet werden.

In einer Ausführungsform der Strommeßanordnung wird vorgesehen, daß mindestens ein Lichtwellenleiter als mechanisch verdrillter Monomode-Lichtwellenleiter ausgebildet ist (DE 28 35 794). Die Lichtwellenleiter werden für die Realisierung des verteilten Stromsensors im Kabel auf einer längeren Strecke, vorzugsweise im Kabelschirmbereich, integriert.

In einer besonderen Ausgestaltung wird vorgeschlagen, den Lichtwellenleiter in Form einer Schraubenfeder um eine Stützfaser zu winden und gegen Zurückdrehen zu fixieren. Einzelheiten des Winden des Lichtwellenleiters sind in der Dissertation von Holger Hirsch, Universität Dortmund 1991, beschrieben. Dieser Typ Lichtwellenleiter ist einfach herstellbar und daher kostengünstiger als Lichtwellenleiter, denen die Eigenschaft der Polarisationserhaltung im Ziehprozeß aufgeprägt werden muß.

Die Stützfaser kann selbst ein Lichtwellenleiter sein, so daß sie als informationsführender Lichtwellenleiter der Strommeßanordnung einsetzbar ist. Dies bringt einen weiteren Vorteil mit sich, weil die Stützfaser funktional im Meßsystem nutzbar ist. Während des Umeinanderwindes verdrillen sich beide Lichtwellenleiter mit dem gleichen Schlag umeinander (Doppelschraube). Der als Stützfaser eingesetzte informationsführende Lichtwellenleiter kann auch als Sensorlichtwellenleiter, z.B. für Zwecke der Übermittlung von Betriebszuständen des Kabels (Temperaturen oder Drücke) oder als Rückführleitung der Signale der Strommeßanordnung eingesetzt werden. Insofern entsteht eine symmetrische Ausgestaltung beider doppelt-gewundenen Lichtwellenleiter mit jeweils austauschbarer Beanspruchung des einen oder des anderen. Der zweite Lichtwellenleiter bleiben der Doppelschraube kann aber auch in Reserve liegen und nur bei Bedarf aktiviert werden. Unabhängig von seiner Betriebsweise (Sensor für Betriebszustände oder Stromsensor) kann jeder Lichtwellenleiter des verteilten Stromsensors als Kommunikationslichtwellenleiter verwendet werden.

Die Strommeßanordnung besteht aus 2 Stromsensoren, von denen einer eine eng und einer eine weit gewickelte Lichtwellenleiterspule ist. Die konzentrierte Faraday-Spule ist befindet sich auf der Einspeiseseite der Kabelstrecke. Die Strommeßanordnung ist mindestens einer Energieader im Energiekabel zugeordnet.

Jede Faraday-Spule ist für sich ein Betriebsstromsensor. Werden beide Sensorsignale verglichen, ist bei Fehlerfreiheit in der Kabelstrecke die Meßgröße Null.

Liegt ein Fehler an beliebiger Stelle der Kabelstrecke vor (Erdschluß, Phasenschluß) fließt der Betriebsstrom an der Fehlerstelle ab. Damit mißt der verteilte Stromsensor den Fehlerstrom gewichtet mit der auf die Länge der Kabelstrecke bezogenen Distanz des Fehlerorts vom Anfang (Einspeiseseite) der Kabelstrecke.

Beide Stromsensoren werden in einem eine Meßstrecke bestimmenden Kabelabschnitt installiert.

Wegen des Spiegels am Ende der Sensorandordnung gilt für die Faraday-Drehung φ der konzentrierten Faraday-Spule:

$$\phi1 = 2\,V\,N1\,I.$$

I ist der Strom am Anfang der Energiestrecke; V ist die Verdet-Konstante, N1 die Windungszahl der konzentrierten Sensorspule.

Die Faraday-Drehung ist in der verteilten Faraday-Spule bei einem Fehler an der Stelle z (Koordinate des Fehlerstromorts) bei einer Streckenlänge L:

$$\phi2 = 2\,V\,N2\,I\,z/L.$$

Die Meßsignale der Faraday-Spulen werden einem elektronischen System zugeführt und dort ausgewertet. Beide Faraday-Meßwerte φ1 und φ2 werden ins Verhältnis gesetzt, wobei die Genauigkeit unabhängig ist von der Lage des Fehlerorts z, solange auswertbare Signale vorliegen. Also im Ergebnis:

$$\phi2/\phi1 = z\,N2/(L\,N1).$$

Das Verhältnis der Meßsignale liefert also den Fehlerort z, bzw. die relative Entfernung z/L des Fehlerorts von Beginn der Kabelstrecke, wobei sich die Beziehung noch vereinfachen würde, wenn in beiden Faraday-Spulen gleiche Windungszahlen N1,N2 vorgesehen werden.

Es gibt 2 Typen von Schirmstromleitungen. Die eine Form ist die der Rohrform, die durch geradlinige Ausbreitung des Schirmstroms gekennzeichnet ist. Besondere Aufmerksamkeit allerdings verlangt die Installation des verteilten Stromsensors, wenn die Schirmstromleitung als geschraubte Leitung im Kabel liegt. Die Anordnung des verteilten Sensors für diesen Fall muß berücksichtigen, daß das Magnetfeld des Schirmstroms in Längsrichtung des Lichtwellenleiters wirkt und damit der Schirmstrom die Messung verfälschen kann.

Die verteilte Faraday-Spule wird bei einer um die Energieaderachse geschraubt geführten Schirmstromleitung aus zwei Spulen aufgebaut. Es wird eine Lichtwellenleiterspule unter den Schirm und im Gegenschlag zur Schirmstromleitung gelegt. An das Ende dieser Spule (also am Ende der Kabelstrecke) wird eine zweite Lichtwellenleiterspule angefügt, die im Schirm parallel zur Schirmstromleitung liegt und bis zum Anfang der Kabelstrecke zurückläuft. Das Ende dieser Spule wird mit einem Spiegel versehen. Die Summe der Wicklungen beider Lichtwellenleiterspulen entspricht der Windungszahl N2.

Die beschriebene Ausführung ist unabhängig von der Reihenfolge der Anordnung der Teilspulen, so daß die Anordnung beider Teilspulen auch so sein kann, daß der Lichtweg zuerst eine Lichtwellenleiterspule im Schirm und dann eine Lichtwellenleiterspule unter dem Schirm durchläuft.

Temperatureffekte in mechanisch tordierten Lichtwellenleitern erzeugen Störeinflüsse auf die Lage der Polarisationsebene in Lichtwellenleitern, die die Nutzeffekte überlagern können. Es wird daher vorgesehen, daß am Ende jeden Stromsensors ein Spiegel zur Reflexion der Signale zum Anfang des Sensors vorhanden ist. Mit dieser Maßnahme werden reziproke Effekte im Lichtwellenleiter kompensiert. Insbesondere tritt mit dieser Maßnahme eine Vereinfachung der Strommeßanordnung ein, weil durch die Rückführung der optischen Signale an die Einkoppelstelle eine weitere Auskoppelstelle überflüssig wird. Die Strommeßanordnung wird einseitig betreibbar.

Die Wahl der Zugriffsstelle auf die Strommeßanordnung richtet sich nach den technischen Gegebenheiten. Es wird vorgeschlagen, diese Stelle auf der Einspeiseseite der Kabelstrecke zu wählen. Unabhängig von der Wahl der Zugrifsstelle - wird ein am Ende der Kabelstrecke angeschlossener Verbraucher (z.B. Transformator) zusammen mit der Kabelstrecke überwachbar, wenn dieser mit Lichtwellenleitern ausgestattet ist und die Lichtwellenleitersensoren des Verbrauchers mit den Lichtwellenleitern der Strommeßanordnung durchverbunden werden.

Die Erfindung ist nicht nur in Einleiterkabeln sondern auch in Mehrphasenleitungen oder Kabeln mit Mehrfachadern einsetzbar, wobei für jede Phase oder jede Energieader die Strommeßanordnung im Kabel schon beim Herstellungsvorgang integriert wird.

Konzentrierte Faraday-Spulen sind kurz. Aus wirtschaftlichen Gründen werden sie nicht im Kabel integriert, obwohl dies technisch machbar ist. Konzentrierte Faraday-Spulen werden vorteilhafterweise als aufschiebbare Spule hergestellt und über die Meßstellen geschoben und fixiert.

Die Unterbringung des Spiegels wird mittels Muffen oder Endverschlüssen bewerkstelligt, deren Ausgestaltung dem Fachmann geläufig ist. Im einfachsten Fall wird in der Kabelstrecke ein Kabel eingesetzt, in dem die verteilte Faraday-Spule vollständig integriert ist.

Anstelle von besonders ausgestalteten Garnituren bietet es sich an, Übergangsorgane (Muffen, Endverschlüsse, Isolatoren, Garnituren) von Energiestrecken so auszugestalten, daß sie die einspeiseseitige konzentrierte Spule und Einrichtungen der Sensoren, wie Spiegel, Ein- und Auskoppeleinrichtungen für Licht mit aufnehmen. Durch die Integration der Lichtwellenleiter in Muffen oder Endverschlüssen, oder die Integration eines oder beider Enden der konzentrierten Faraday-Spule in einer Muffe oder einem Endverschluß, kann der Übergang von der Kabelstrecke zu einem Verbraucher oder zu einer weiteren Kabelstrecke sehr kurz realisiert werden. Darin liegt ein besonderer Vorteil der Strommeßanordnung, nämlich räumlich und zeitlich lückenlos an die Überwachung der Kabelstrecke die Betriebsüberwachung weiterer Netzkomponenten anschließen zu können.

Wie schon erwähnt, kann der Lichtwellenleiter des verteilten Stromsensors als Sensor für Betriebzustände oder als Kommunikationslichtwellenleiter auf der Kabelstrecke ausgebildet sein. Als typische Sensoren sind Temperatursensoren für Energiestrecken von Bedeutung. Als Sensor für Betriebszustände ist insbesondere der als Stützfaser eingebrachte Lichtwellenleiter einsetzbar. Es ist für den Betreiber einer Energiestrecke von besonderem Interesse, Heißstellen (hot spots) aufspüren zu können. Die Überwachung der Temperatur kann unabhängig vom Betrieb der Strommeßanordnung zeitlich intermittierend oder gleichzeitig mit dem Strommeßvorgang stattfinden. Als Verfahren bieten sich Zeit- und/oder Wellenlängenmultiplexverfahren an. Insbesondere ergibt sich bei auf optischen Rückstreueffekten (z.B. Raman-Streuung) beruhenden Temperaturmeßverfahren ein der Strommessung angepaßtes, einseitig betreibbares Sensorsystem.

Die Strommeßanordnung hat den besonderen Vorteil, daß sie in Distanz- oder Vergleichsschutzeinrichtungen eingesetzt werden kann. Hierbei wird die Meßanordnung innerhalb eines Leitungsschutz- und/oder Überwachungssystem als Komponente verwendet. Eine solche Konfiguration ist herkömmlichen Einrichtungen zum Distanz- oder Vergleichsschutz überlegen. In einer verfahrensmäßigen Anwendung wird vorgeschlagen, die Meßwerte beider Stromsensoren in eine Auswertestation (die z. B. Komponente einer Netzleitwarte sein kann) zu führen und dort Fehlerstromstärke und relativen Fehlerstromort ermitteln zu lassen.

In einer anderen Verfahrensweise werden Betriebsgrößenmessungen in einer Energiestrecke mit der Strommeßanordnung vorgeschlagen, indem Signale der Strommeßsensoren ebenfalls zu einer Auswertestation geführt und ausgewertet werden. Zusätzlich oder anstelle von Betriebsgrößenmessungen können Kommunikationsdaten über die Lichtwellenleiter geschickt werden. In diesem Fall muß an jedem Ende der Strommeßanordnung der Kommunikationslichtwellenleiter aus der Kabelstrecke herausgeführt und mit endseitigen Nachrichtenstationen verbunden werden.

Unabhängig von der Betriebsweise (entweder als Stromsensor oder als Betriebsgrößensensor) wird auf die Kabelstrecke nur von einer Seite aus zugegriffen. Das gesamte Spektrum der Meß- und Auswertesignale stehen an diesem einen Ende zur Weiterverarbeitung einer Auswerteeinrichtung in einer Leitwarte zur Verfügung. Bekannte Differentialschutzanordnungen haben den Nachteil, daß bei ihnen an beiden Enden der Kabelstrecke Verbindungen zum Kabel vorhanden sein müssen. Bei der Strommeßanordnung entfällt die Notwendigkeit externer Meßsignal- und Auslösesignalübertragung zwischen beiden Enden der Kabelstrecke.

Der Schutzbereich beträgt 100 % der Kabelstrecke. Dies wird durch herkömmlichen Distanzschutz nicht erreicht. Bei der Verwendung der Strommeßanordnung (zum Beispiel als Komponente in einem Leitungsschutz- und/oder Überwachungssystem) kann absolute Selektivität erzielt werden (d.h. die fehlerhafte Strecke kann gezielt abgeschaltet werden). Diese Eigenschaft ist insbesondere von Vorteil, wenn bestehende Energieversorgungsnetze um zusätzliche, einseitig gespeiste Kabelstrecken erweitert werden (Stichstrecke). Die Möglichkeit der Fehlerortung erlaubt eine eindeutige Zuordnung des Fehlers zum bestehenden Netz oder zum Kabel in der Stichstrecke, so daß bereits im Betrieb befindliche Schutzeinrichtungen in ihrer Funktion nicht beeinträchtigt werden.

Ausführungsbeispiele der Erfindung werden in den Figuren näher beschrieben. Sie zeigen im Einzelnen:

Fig. 1 und Fig. 2 schematisch die Strommeßanordnung und
Fig. 3 eine Ausführungsform des verteilten Stromsensors.

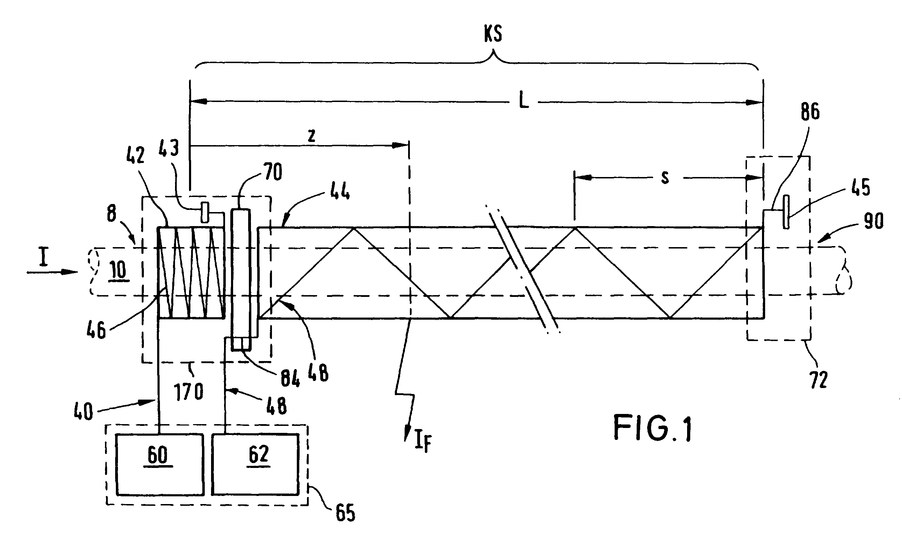

In Fig. 1 ist schematisch die Strommeßanordnung dargestellt. Sie besteht aus einem konzentrierten und einem über die Kabelstrecke **KS** verteilten Faraday-Stromsensor aus jeweils einer Lichtwellenleiterspule **42,44** bei einem Kabel **10**.

Die erste Lichtwellenleiterspule **42** besteht aus dem Lichtwellenleiter **46** und ist auf der Einspeiseseite **8** der Kabelstrecke **KS** als konzentrierte Spule gewickelt. Die Lichtwellenleiterspule **42** wird in einer einfachen Ausführung als auf das Kabel **10** aufgeschobene Spule realisiert. Die zweite Lichtwellenleiterspule **44** mit dem Lichtwellenleiter **48** ist mit langem Schlag **s** über der Kabelstrecke **KS** verteilt.

Die Länge der Kabelstrecke **KS** ist mit **L**, die Ortskoordinate der Fehlerstelle auf der Kabelstrecke **KS** wird mit **z** bezeichnet. Der in der Energieader **12** (**Fig.** 3) des Kabels fließende Betriebsstrom wird mit **I** bezeichnet. Ein Fehlerstrom (Erdschluß) trägt die Bezeichnung $I_F$.

Von außerhalb des Kabels wird die Strommeßanordnung **42,44** über die Lichtwellenleiter **40,48** von den Steuer- oder Auswertestationen **60,62** angesteuert, die in einer Leitwarte **65** zusammengefaßt sind. In der Leitwarte **65** werden die Meßwerte und physikalische Daten über Betriebszustände der Kabelstrecke ermittelt und ausgewertet und/oder Kommunikationsaufgaben abgewickelt. Die Strommeßanordnung hat wegen des nur an einer Stelle vorhandenen Zugangs auf die Kabelstrecke eine sehr einfache topologische Struktur.

Beide Lichtwellenleiterspulen **42,44** haben am Ende einen Spiegel **43,45** zur Reflexion des Lichts zum Anfang der Lichtwellenleiterspulen **42,44**.

Der Übergang zwischen dem Kabel **10** und dem Kabel in der Kabelstrecke **KS** wird mit einer Kabelmuffe **70** hergestellt. Durch die Kabelmuffe **70** ist der Lichtwellenleiter **48** hindurchgeführt (Bezugszeichen **84**). Mit einer zweiten Muffe **72** wird das Kabel aus der Kabelstrecke **KS** an der Stelle **90** an ein weiterführendes Kabel oder an einen Endverbraucher verbunden. Es kann in der Muffe **72** das Ende der Lichtwellenleiterspule **44** und der Spiegel **45** integriert sein.

Gestrichelt ist in der **Fig.** 1 eine Installationsmuffe **170** dargestellt, die anstelle der Muffe **70** vorgesehen werden kann. Die Installationsmuffe **170** umfaßt neben der Durchführung der Energieader **12** des Kabels **10** und der Schirmleitung **80** (**Fig.** 3) auch die konzentrierte Faraday-Spule **42**, einschließlich Spiegel **43**, und die Lichtwellenleiterverbindungen zur Leitwarte **65**. Die Installationsmuffe **170** ist eine komplette Baueinheit, in die die erwähnten Teile der Strommeßanordnung integriert sind.

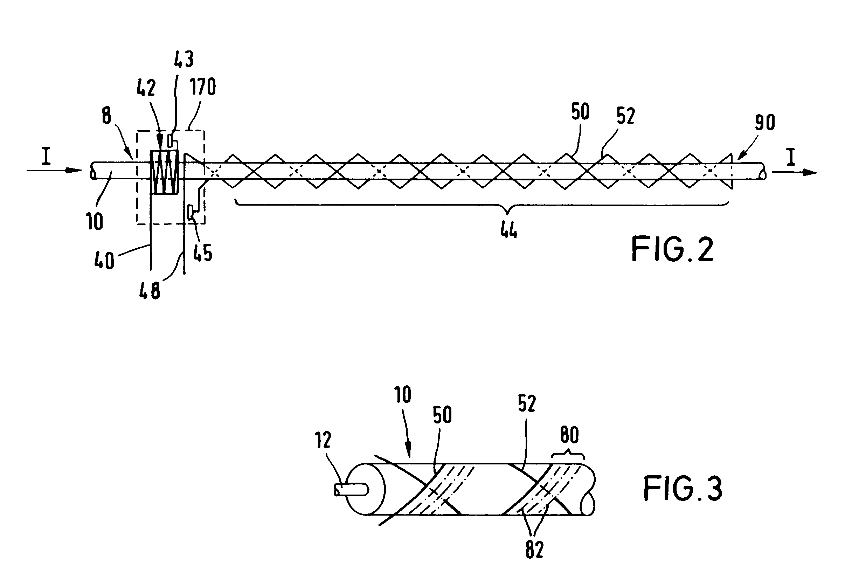

Die **Fig.** 2 zeigt schematisch die Darstellung für die Anordnung der verteilten Faraday-Spule **44**, deren Schirmdrahtleitung **80** geschraubt geführt ist. Die **Fig.** 3 zeigt dies im Detail. Wie schon in **Fig.** 1 dargestellt, befindet sich am Ende der verteilten Faraday- Spule **44** ein Spiegel **45**.

Wegen des Magnetfeldes des geschraubt geführten Schirmstroms wird eine darauf abgestimmte Anordnung der verteilten Faraday-Spule **44** gewählt. Die in der Kabelstrecke mit langem Schlag liegende Faraday-Spule **44** wird aus zwei Lichtwellenleiter-Leitungen **50,52** gebildet. Ein Lichtwellenleiter **52** wird als Spule unter den Kabelschirm **80** im Gegenschlag zu ihm gelegt. Der andere Lichtwellenleiter **50** läuft als zweite Spule zum Anfang der Kabelstrecke im Kabelschirm **80** parallel zu den (strichpunktiert gezeichneten) Schirmdrähten **82** zurück. Die Summe der Windungen beider Lichtwellenleiterspulen **50,52** bilden die maßgebliche Windungszahl **N2** des konzentrierten Stromsensors **44**. Auf den unter dem Schirm **80** liegenden Lichtwellenleiter **52** wirkt das Magnetfeld der Energieader **12** und das Magnetfeld des Schirmstroms. Die Wirkung des Magnetfeldes der Schirmstromleitung **80** wird durch diese Anordnung kompensiert. Die Reihenfolge der Anordnung beider Lichtwellenleiter **50,52** ist beliebig. D.h. für die Kompensationswirkung ist es unerheblich, ob das Licht zuerst im Lichtwellenleiter **52** unter dem Schirm zum Ende der Kabelstrecke **KS** und anschließend im Lichtwellenleiter **50** in der Schirmlage bis zum Spiegel **45** läuft oder ob es zuerst im Lichtwellenleiter **50** in der Schirmlage zum Ende der Kabelstrecke **KS** und dann unter dem Schirm zum Spiegel **45** läuft. Eine Installationsmuffe **170** kann an der Einspeiseseite **8** der Kabelstrecke vorgesehen sein. Sie umfaßt neben der konzentrierten Faraday-Spule **42**, die Durchführungen der Lichtwellenleiter nach außen und auch die Spiegel **43,45**.

## Patentansprüche

1. Strommeßanordnung für eine einseitig gespeiste Strecke (**KS**) einer Energieader (**12**) eines Energiekabels (**10**), mit mindestens zwei polarisationserhaltenden Lichtwellenleitern (**46, 48**), die als Faraday-Spulen (**42, 44**) ausgebildet sind und mit an einem Ende der Strecke (**KS**) vorhandenen Einrichtungen zum Ein- und Auskoppeln von Licht in die bzw. aus den Lichtwellenleitern (**46, 48**) und mit einer Einrichtung (**65**) zur Auswertung ausgekoppelter optischer Signale, **dadurch gekennzeichnet,** daß, mindestens einer Energieader (**12**) im Energiekabel (**10**) zugeordnet,

   - die Strommeßanordnung aus einer auf der Einspeiseseite (**8**) der Strecke (**KS**) liegenden konzentrierten Faraday-Spule (**42**) und aus einer über die Strecke (**KS**) verteilten Faraday-Spule (**44**) als Faraday-Stromsensoren gebildet ist und
   - daß am Ende jeden Stromsensors (**42,44**) ein Spiegel (**43,45**) zur Reflexion der Signale vorhanden ist.

2. Strommeßanordnung nach Anspruch 1, **dadurch gekennzeichnet,** daß bei einer um die Energieaderachse geschraubt geführten Schirmleitung (**80**) der verteilte Stromsensor (**44**), unabhängig von der Reihenfolge der Anordnung, aus einer unter dem Schirm (**80**) und im Gegenschlag zur Schirmleitung liegenden Lichtwellenleiterspule (**52**) und vom Ende (**90**) der Strecke (**KS**) mit einer im Schirm (**80**) parallel zur Schirmleitung liegenden zur Einspeiseseite (**8**) der Strecke (**KS**) zurückgeführten anderen Lichtwellenleiterspule (**50**) gebildet ist, die dort mit einem Spiegel (**45**) versehen ist.

3. Strommeßanordnung nach einem der vorhergehenden Ansprüche, **dadurch gekennzeichnet**, daß die Einrichtungen zum Ein- und Auskoppeln von Licht der Steuer- und Auswertestationen (**60,62**) an der Einspeiseseite (**8**) der Strecke (**KS**) liegen.

4. Strommeßanordnung nach einem der vorhergehenden Ansprüche, **dadurch gekennzeichnet**, daß als Lichtwellenleiter (**46,48**) in mindestens einem Faraday-Stromsensor (**42,44**) ein mechanisch tordierter Lichtwellenleiter eingesetzt ist.

5. Strommeßanordnung nach Anspruch 4, **dadurch gekennzeichnet**, daß mindestens ein Lichtwellenleiter (**46,48**) um eine Stützfaser schraubenförmig gewunden ist.

6. Strommeßanordnung nach Anspruch 5, **dadurch gekennzeichnet**, daß die Stützfaser als polarisationserhaltender Lichtwellenleiter ausgebildet ist.

7. Strommeßanordnung nach einem der Ansprüche 1 bis 3, **dadurch gekennzeichnet**, daß als Lichtwellenleiter (**46,48**) Fasern vom Typ spun high birefringence eingesetzt sind.

8. Strommeßanordnung nach einem der Ansprüche 5 oder 6, **dadurch gekennzeichnet**, daß die Stützfaser und/oder der Lichtwellenleiter (**46,48**) mindestens eines Faraday-Stromsensors (**42,44**) als Sensor für Betriebsgrößen und/oder als Kommunikationslichtwellenleiter ausgebildet ist.

9. Strommeßanordnung nach einem der vorhergehenden Ansprüche, **dadurch gekennzeichnet**, daß mindestens ein Faraday-Stromsensor (**42, 44**) für jede Phase oder jede Energieader (**12**) in dem Energiekabel (**10**) integriert ist.

10. Strommeßanordnung nach einem der vorhergehenden Ansprüche, **dadurch gekennzeichnet**, daß Durchführungen (**84**) der Lichtwellenleiter (**46,48**) von den Faraday-Stromsensoren (**42,44**) zur Steuer- und Auswertestation (**60,62**) in Muffen (**70**) integriert sind.

11. Strommeßanordnung nach Anspruch 10, **dadurch gekennzeichnet**, daß der Anfang und/oder das Ende des verteilten Faraday-Stromsensors (**44**) und die zugehörigen Durchführungen (**84, 86**) des Lichtwellenleiters (**48**) in einer Muffe (**70,72**) integriert sind.

12. Strommeßanordnung nach einem der vorhergehenden Ansprüche, **dadurch gekennzeichnet**, daß der konzentrierte Faraday-Stromsensor (**42**) in einer Installationsmuffe (**170**) integriert ist.

13. Strommeßanordnung nach einem der vorhergehenden Ansprüche, **dadurch gekennzeichnet**, daß die Faraday-Meßwerte der Faraday-Strommeßanordnung (**42,44**) in eine Leitwarte (**65**) zur Ermittlung der Strom- oder Fehlerstromstärke ($I_F$) und des relativen Fehlerstromortes (**z/L**) geführt sind.

14. Strommeßanordnung nach einem der Ansprüche 1 bis 13, **dadurch gekennzeichnet**, daß mit Hilfe von zwischen jeweils an den Enden (**8,90**) der Kabelstrecke (**KS**) angeschlossenenen Kommunikationsstationen auch eine Betriebsgrößenüberwachung und/oder eine Datenübertragung über die Faraday-Strommeßanordnung (**42,44**) durchgeführt ist.

15. Strommeßanordnung nach Anspruch 14, **dadurch gekennzeichnet**, daß das Strommessen und die Betriebsgrößenüberwachung und/oder das Datenübertragen im Multiplexbetrieb vorgenommen ist.

16. Strommeßanordnung nach einem der vorhergehenden Ansprüche, **dadurch gekennzeichnet**, daß die Faraday-Strommeßanordnung (**42,44**) als Komponente in einem Leitungsschutz- und/oder Überwachungssystem verwendet ist.

**Claims**

1. A current-measuring arrangement for a section (**KS**), fed from one end, of a power core (**12**) of a power cable (**10**), having at least two polarisation-maintaining optical waveguides (**46,48**) which are designed as Faraday coils (**42,44**), and having devices which are present at one end of the section (**KS**) and are intended for injecting and extracting light into and from the optical waveguides (**46,48**), and having a facility (**65**) for the evaluation of extracted optical signals, characterised in that, assigned to at least one power core (**12**) in the power cable (**10**),

   - the current-measuring arrangement is formed from a concentrated Faraday coil (**42**) lying on the infeed side (**8**) of the section (**KS**) and from a Faraday coil **(44)** distributed over the section **(KS)** as Faraday current sensors and

- in that a mirror **(43,45)** for reflecting the signals is present at the end of each current sensor **(42,44)**.

2. A current-measuring arrangement according to Claim 1, **characterised** in that, in the case of a shielding line **(80)** run helically around the axis of the power core, the distributed current sensor **(44)**, irrespective of the order of the arrangement, is formed from an optical-waveguide coil **(52)** lying under the shield **(80)** and with a cross lay relative to the shielding line and, from the end **(90)** of the section **(KS)**, with another optical-waveguide coil **(50)** which lies in the shield **(80)** parallel to the shielding line, is led back to the infeed side **(8)** of the section **(KS)** and is fitted there with a mirror **(45)**.

3. A current-measuring arrangement according to one of the preceding claims, **characterised** in that the devices for injecting and extracting light of the control and evaluating stations **(60,62)** lie on the infeed side **(8)** of the section **(KS)**.

4. A current-measuring arrangement according to one of the preceding claims, **characterised** in that a mechanically twisted optical waveguide is employed as the optical waveguides **(46,48)** in at least one Faraday current sensor **(42,44)**.

5. A current-measuring arrangement according to Claim 4, **characterised** in that at least one optical waveguide **(46,48)** is wound helically around a supporting fibre.

6. A current-measuring arrangement according to Claim 5, **characterised** in that the supporting fibre is designed as a polarisation-maintaining optical waveguide.

7. A current-measuring arrangement according to one of Claims 1 to 3, **characterised** in that fibres of the spun high birefringence type are employed as the optical waveguides **(46,48)**.

8. A current-measuring arrangement according to one of Claims 5 or 6, **characterised** in that the supporting fibre and/or the optical waveguide **(46,48)** of at least one Faraday current sensor **(42,44)** is designed as a sensor for operating quantities and/or as a communication optical waveguide.

9. A current-measuring arrangement according to one of the preceding claims, **characterised** in that at least one Faraday current sensor **(42,44)** for each phase or each power core **(12)** is integrated in the power cable **(10)**.

10. A current-measuring arrangement according to one of the preceding claims, **characterised** in that leadthroughs **(84)** of the optical waveguides **(46,48)** from the Faraday current sensors **(42,44)** to the control and evaluating station **(60,62)** are integrated in coupling boxes **(70)**.

11. A current-measuring arrangement according to Claim 10, **characterised** in that the beginning and/or the end of the distributed Faraday current sensor **(44)** and the associated leadthroughs **(84,86)** of the optical waveguide **(48)** are integrated in a coupling box **(70,72)**.

12. A current-measuring arrangement according to one of the preceding claims, **characterised** in that the concentrated Faraday current sensor **(42)** is integrated in an installation coupling box **(170)**.

13. A current-measuring arrangement according to one of the preceding claims, **characterised** in that the Faraday measured values of the Faraday current-measuring arrangement **(42,44)** are passed to a control centre **(65)** for the determination of the intensity $(I_F)$ of the current or fault current and of the relative location **(z/L)** of the fault current.

14. A current-measuring arrangement according to one of Claims 1 to 13, **characterised** in that monitoring of the operating quantities and/or data transmission is also carried out via the Faraday current-measuring arrangement **(42,44)** with the aid of communication stations connected between [sic] to each of the ends **(8,90)** of the cable section **(KS)**.

15. A current-measuring arrangement according to Claim 14, **characterised** in that the current measurement and the monitoring of the operating quantities and/or the data transmission is carried out in multiplex operation.

16. A current-measuring arrangement according to one of the preceding claims, **characterised in that** the Faraday current-measuring arrangement **(42,44)** is used as a component in a line-protection and/or monitoring system.

**Revendications**

1. Dispositif de mesure du courant pour un tronçon **(KS)** d'un conducteur de transport d'énergie **(12)** appartenant à un câble de transport d'énergie **(10)** qui est alimenté unilatéralement, comprenant au moins deux guides d'ondes lumineuses **(46, 48)** conservant la polarisation, qui constituent des bobines de Faraday **(42, 44)** , ainsi que des dispositifs pour injecter de la lumière dans les guides d'ondes lumineuses (46, 48) et l'en extraire, prévus à une même extrémité du tronçon (KS) et qu'un dispositif (65) d'analyse des signaux optiques extraits, caractérisé en ce qu'à au moins un conducteur de transport d'énergie (12) du câble de transporteur d'énergie (10), est associé,

- le dispositif de mesure du courant composé d'une bobine de Faraday concentrée (42) placée sur le côté d'alimentation (8) du tronçon (KS), et d'une bobine de Faraday répartie sur le tronçon (KS), qui constituent des capteurs de courant de Faraday, et
- en ce qu'un miroir (43, 45) est prévu à l'extrémité de chaque capteur de courant (42, 44) pour assurer la réflexion des signaux.

2. Dispositif de mesure du courant selon la revendication 1, caractérisé en ce que, dans le cas d'un conducteur de blindage (80) disposé en hélice autour de l'axe du conducteur de transport d'énergie, le capteur de courant réparti (44) est formé, indépendamment de l'ordre de succession de l'agencement, d'une bobine de guide d'ondes lumineuses (52) disposée sous le blindage (80) et enroulée en sens inverse du conducteur de blindage (80) et, d'une autre bobine de guide d'ondes lumineuses (50) revenant de la fin (90) du tronçon (KS) jusqu'au côté d'alimentation (8) du tronçon (KS) et disposée dans le blindage (80) parallèlement au conducteur de blindage, cette autre bobine étant munie d'un miroir (45) à cet endroit.

3. Dispositif de mesure du courant selon l'une des revendications précédentes, caractérisé en ce que les dispositifs pour l'injection et l'extraction de la lumière des postes de commande et d'analyse (60, 62) se trouvent au côté d'alimentation (8) du tronçon (KS).

4. Dispositif de mesure du courant selon l'une des revendications précédentes, caractérisé en ce qu'on utilise, comme guide d'ondes lumineuses (46, 48) dans au moins un capteur de courant de Faraday (42, 44), un guide d'ondes lumineuses torsadé mécaniquement.

5. Dispositif de mesure du courant selon la revendication 4, caractérisé en ce qu'au moins un guide d'ondes lumineuses (46, 48) est enroulé en hélice autour d'une fibre de support.

6. Dispositif de mesure du courant selon la revendication 5, caractérisé en ce que la fibre de support constitue un guide d'ondes lumineuses conservant la polarisation.

7. Dispositif de mesure du courant selon l'une des revendications 1 à 3, caractérisé en ce qu'on utilise comme guides d'ondes lumineuses (46, 48) des fibres du type "spun high birefringence".

8. Dispositif de mesure du courant selon la revendication 5 ou 6, caractérisé en ce que la fibre de support et/ou le guide d'ondes lumineuses (46, 48) d'au moins un capteur de courant de Faraday (42, 44) constitue un capteur de grandeurs de fonctionnement et/ou un guide d'ondes lumineuses de communication.

9. Dispositif de mesure du courant selon l'une des revendications précédentes, caractérisé en ce qu'au moins un capteur de courant de Faraday (42, 44) est intégré dans le câble de transport d'énergie (10) pour chaque phase ou pour chaque conducteur de transport d'énergie (12).

10. Dispositif de mesure du courant selon l'une des revendications précédentes, caractérisé en ce que des traversées (84) des guides d'ondes lumineuses (46, 48) menant des capteurs de courant de Faraday (42, 44) aux postes de commande et d'analyse (60, 62) sont intégrées dans des manchons (70).

11. Dispositif de mesure du courant selon la revendication 10, caractérisé en ce que le début et/ou la fin du capteur de courant de Faraday réparti (44) et les traversées correspondantes (84, 86) du guide d'ondes lumineuses (48) sont intégrés dans un manchon (70, 72).

12. Dispositif de mesure du courant selon l'une des revendications précédentes, caractérisé en ce que le capteur de courant de Faraday concentré (42) est intégré dans un manchon d'installation (170).

13. Dispositif de mesure du courant selon l'une des revendications précédentes, caractérisé en ce que les valeurs de mesure de Faraday du dispositif de mesure du courant de Faraday (42, 44) sont transmises à un dispositif de surveillance de la conduction (65) pour déterminer l'intensité du courant ou l'intensité du courant de défaut ($I_F$) et la position relative du courant de défaut (z/L).

14. Dispositif de mesure du courant selon l'une des revendications 1 à 13, caractérisé en ce qu'à l'aide de postes de communication raccordés aux extrémités (8, 90) du tronçon de câble (KS), on transmet aussi à travers le dispositif de mesure de courant de Faraday (42, 44), une surveillance des paramètres de fonctionnement et/ou une transmission de données.

15. Dispositif de mesure du courant selon la revendication 14, caractérisé en ce que la mesure du courant et la surveillance des paramètres de fonctionnement et/ou la transmission des données s'effectue en mode multiplex.

16. Dispositif de mesure du courant selon l'une des revendications précédentes, caractérisé en ce que le dispositif de mesure du courant de Faraday (42, 44) est utilisé en tant qu'élément constitutif d'un système de protection de la ligne et/ou de surveillance.

EP 0 584 447 B1

KS

L

z

s

86

45

90

72

42 43

70

44

8

I

10

46

84 48

40

170

48

$I_F$

60

62

65

FIG.1

FIG.2

FIG.3